Europäisches Patentamt

(19) European Patent Office

Office européen des brevets

(11) Publication number: **0 106 072**
**A2**

(12) # EUROPEAN PATENT APPLICATION

(21) Application number: 83108283.9

(51) Int. Cl.³: **H 01 L 29/91**

(22) Date of filing: 23.08.83

(30) Priority: 20.09.82 US 419852

(43) Date of publication of application:
25.04.84 Bulletin 84/17

(84) Designated Contracting States:
DE FR GB NL

(71) Applicant: GENERAL ELECTRIC COMPANY
1 River Road
Schenectady New York 12305(US)

(72) Inventor: Adler, Michael Stuart
2238 Budd Terrace
Schenectady New York 12309(US)

(72) Inventor: Baliga, Bantval Jayant
3 Clove Court
Clifton Park New York 12065(US)

(74) Representative: Sieb, Rolf, Dr. et al,
European Patent Attorney Kaiserstrasse 41
D-6000 Frankfurt (Main) 1(DE)

(54) High voltage Schottky barrier diode.

(57) A Schottky barrier diode includes a voltage-supporting layer of gallium arsenide with a dopant concentration below about $10^{16}$ impurity atoms per cubic centimeter, enabling it to support high voltage. The Schottky barrier diode attains nearly an ideal reverse breakdown voltage and has an extremely low reverse leakage current without the requirement of edge termination structure, such as a passivation layer or a guard ring.

FIG. 1

10216- RD-13,251

## HIGH VOLTAGE SCHOTTKY BARRIER DIODE

### Background of the Invention

The present invention relates to a Schottky barrier diode, and, more particularly, to such diode including a voltage-supporting layer which is comprised of gallium arsenide semiconductor material and is capable of supporting high reverse voltages.

A Schottky barrier diode is a semiconductor device including semiconductor material of only one conductivity type and comprising a substrate of one dopant concentration and a voltage-supporting layer thereon of lower dopant concentration. A first electrode adjoins the more lightly doped voltage-supporting layer and forms a Schottky barrier rectifying contact therewith, and a second electrode adjoins the more heavily doped substrate and forms an ohmic or non-rectifying contact therewith. The volt-ampere characteristic of a Schottky barrier diode is very similar to that of a P-N diode, with its forward current increasing rapidly for increasing, low values of forward bias voltage, and its reverse leakage current remaining relatively low for increasing magnitudes of reverse bias voltage until a reverse breakdown voltage is reached and the diode "breaks down"; that is, its reverse current increase dramatically at such voltage and it is unable to support further increases in reverse voltage.

Gallium arsenide has a particularly desirable property that renders it a desirable semiconductor material for use in a Schottky barrier diode. That is,a gallium arsenide device has a resistance which is about one-twelfth the resistance of a similar device made with commonly-used silicon, for such devices with the same reverse breakdown voltages and forward drops. Accordingly,for a given reverse breakdown voltage and forward voltage drop a gallium arsenide Schottky barrier diode could conduct about 12 times as much current as a silicon Schottky barrier diode of the same size, or could be made about 12 times smaller than a silicon Schottky diode. A Schottky barrier diode capable of blocking current at low reverse voltages, that is, voltages below about 100 volts in magnitude, and which comprises gallium arsenide semiconductor material is known, and described, for example, in an article by A.K. Sinha and J.M. Poate, entitled "Effect of Alloying Behavior on the Electrical Characteristics of n-GaAs Schottky Diodes Metallized with W, Au, and Pt," Appl.Phys.Lett., Vol.23, No. 12 (15 December 1973), pages 666-668. Such low voltage Schottky barrier diode includes a voltage-supporting layer having a dopant concentration of $10^{16}$ impurity atoms per cubic centimeter.

Schottky barrier diodes capable of blocking current at high reverse voltages, that is, voltages greater than about 100 volts in magnitude, and which comprise silicon semiconductor material are known, and described, for example, in L.F. Cordes and M. Garfinkel, "High-Voltage Power Schottky Diodes", General Electric Co. Technical Information Series, Report No.74CRD139, August 1974, pages 1-8. High voltage Schottky barrier diodes comprised of silicon, however, suffer the deficiencies of having a reverse breakdown voltage which is considerably lower than ideal and having a reverse leakage current which is sufficiently high so as to result in significant heating losses.

The foregoing deficiencies of silicon Schottky barrier diodes are known to be the result of "edge effects", which are the effects of the high electrical field gradient that exists in the silicon at the junction where the edge of a Schottky barrier rectifying contact terminates on the silicon. The high electrical field gradient results in premature avalanche breakdown of such silicon Schottky barrier diode at a reverse voltage that is considerably lower than in the ideal case. The ideal case is a theoretical case where both the Schottky barrier rectifying contact and the silicon to which it is attached form infinite parallel planes so that the contact does not terminate upon the silicon, and thus the foregoing high electric field gradient is not present. In an effort to minimize the high electric field gradient in silicon Schottky barrier diodes, various edge termination structures have been developed, involving, for example, specially configuring the semiconductor material to which a rectifying contact adjoins, in conjunction with the use of a passivation layer, as described for example, in the above-referenced article of L.F. Cordes and M. Garfinkel at Figure 5; and incorporating a special semiconductor region known as a guard ring, as described, for example, in S.M. Sze, Physics of Semiconductor Devices, New York: Wiley-Interscience (1969), pages 400-403. These various edge termination structures have only been partially successful, however, permitting a silicon Schottky barrier diode to typically attain only about 63 percent of its ideal breakdown voltage, not eliminating high reverse leakage currents, and adding to the complexity and cost of the diode.

-3-

The prior art fails to contain any teaching that gallium arsenide would react differently than silicon and not be subject to the deficiencies resulting from edge effects. Therefore, because silicon and gallium arsenide are basically similar semiconductor materials, a person skilled in the art would expect that gallium arsenide used in a Schottky barrier diode would also suffer from edge effect problems and require edge termination structure to mitigate such problems.

### Summary of the Invention

An object of our invention is to provide a high voltage Schottky barrier diode that can block current at nearly its ideal reverse voltage.

A further object of our invention is to provide a high voltage Schottky barrier diode whose/leakage current is low up to nearly its reverse breakdown voltage.

A still further object of our invention is to provide a high voltage Schottky barrier diode that attains the foregoing objects without requiring special edge termination structure.

Another object of our invention is to provide a high voltage Schottky barrier diode that can operate unimpaired at high temperature up to at least 300°C.

In accordance with the illustrated embodiment of our invention, we provide a high voltage Schottky barrier diode including a body of gallium arsenide semiconductor material with a substrate layer and a voltage-supporting layer thereon, both doped to N-type conductivity. A Schottky barrier rectifying contact adjoins the voltage-supporting layer and an ohmic contact adjoins the substrate layer.

-4-

The voltage-supporting layer has a dopant concentration below about $10^{16}$ impurity atoms per cubic centimeter. Where the first electrode comprises, by way of example, tungsten that has been annealed at a temperature in excess of about 450°C, the resulting diode is capable of blocking current at high reverse voltages up to nearly its ideal reverse breakdown voltage, and exhibits extremely low leakage current at reverse voltages up to nearly its breakdown voltage. The diode attains these advantages without requiring the use of edge termination structure. The diode also has the capability of operating in an unimpaired condition at high temperatures up to at least 300°C.

### Brief Description of the Drawings

While the specification concludes with claims particularly pointing out and distinctly claiming the subject matter which we regard as our invention, it is believed that the invention will be better understood from a consideration of the following description in conjunction with the accompanying drawing figures, in which:

FIGURE 1 is a schematic, cross-sectional view in perspective of a high voltage Schottky barrier diode comprising gallium arsenide in accordance with our invention; and

FIGURE 2 is a graphical depiction of the reverse voltage characteristics of both a high voltage, Schottky barrier diode comprising gallium arsenide in accordance with our invention, and a prior art, high voltage, Schottky barrier diode comprising silicon.

## Description of the Preferred Embodiments

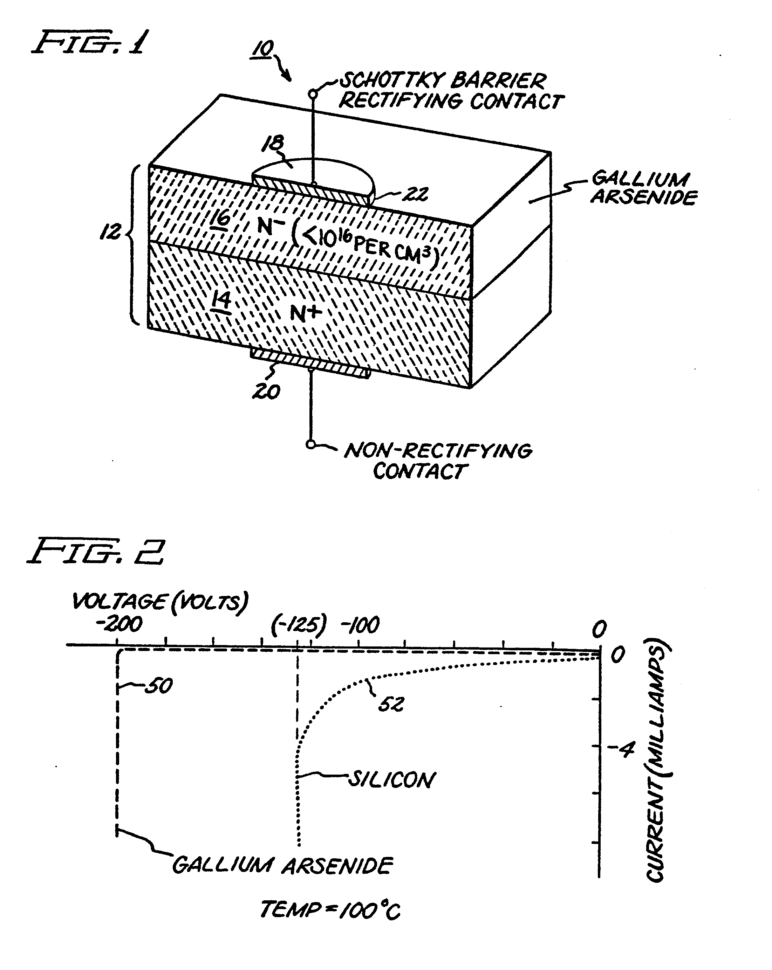

FIGURE 1 illustrates a high voltage Schottky barrier diode 10 in accordance with our invention. Diode 10 includes a body 12 having a substrate layer 14, preferably comprising gallium arsenide, and a voltage-supporting layer 16 of gallium arsenide thereon. Layers 14 and 16 preferably contain N-type dopant impurities, as illustrated. Diode 10 further includes a first electrode 18, which adjoins voltage-supporting layer 16 and forms a Schottky barrier rectifying contact therewith, and a second electrode 20, which adjoins substrate layer 14 and forms a non-rectifying or ohmic contact therewith.

First and second electrodes 18 and 20 are suitably applied to semiconductor body 12 by the known technique of shadow evaporation. First, electrode 18 preferably comprises tungsten which has been annealed at a temperature in excess of about $450^{\circ}C$ for longer than about 60 minutes. A material such as aluminum (not shown) to which leads can be readily soldered is advantageously formed over first electrode 18 to facilitate contact to an external circuit (not shown).

Substrate 14 has a high dopant concentration, e.g., $10^{18}$ impurity atoms per cubic centimeter, so as to form an ohmic contact with second electrode 20 which is attached thereto. Substrate 14 preferably has a (111) crystallographic orientation, although substrates with other orientations can alternatively be used.

Voltage-supporting layer 16 of gallium arsenide preferably comprises an epitaxial layer grown, for example, by either the vapor-phase technique or the liquid-phase technique.

Such techniques are described in details, for example, in a collection of articles complied in David J. Colliver, Compound Semiconductor Technology, Dedham, Massachusetts: Artech House, Inc. (1976) pages 8-40.

In accordance with our invention, the dopant concentration of voltage-supporting layer 16 is less than about $10^{16}$ impurity atoms per cubic centimeter. We have found that diode 10 can block current at reverse voltages up to nearly its ideal reverse breakdown voltage and that it exhibits extremely low reverse leakage current up to its reverse breakdown voltage, at least where first electrode 18 comprises tungsten annealed as described above, or gold. Furthermore, diode 10 attains these advantages without requiring any special structure for terminating edge 22 of first electrode 18 upon voltage-supporting layer 16, in contradistinction to a high voltage Schottky diode comprising silicon. At least this has been experimentally confirmed for diode 10 with reverse breakdown voltages up to 600 volts, and would appear to hold true for diode 10 with higher reverse breakdown voltages. These findings indicate that diode 10 does not suffer from the effects of a high electric field gradient at edge 22 of first electrode 18, contrary to /what the prior art suggests. We have also found that diode 10 operates unimpaired at high temperatures up to at least 300°C, at least where first electrode 18 comprises tungsten annealed as described above.

The reverse characteristics of a gallium arsenide diode 10 and a prior art silicon diode are illustrated in FIGURE 2. Reverse characteristic 50 is for a particular gallium arsenide diode having an ideal reverse breakdown voltage of 200 volts, and reverse characteristic 52 is for a typical prior art, high voltage, silicon Schottky barrier diode, likewise having an ideal reverse breakdown voltage of 200 volts, the characteristics 50 and 52 being measured with both diodes at a temperature of 100°C. (The data for reverse characteristic 52 is taken from FIGURE 10 of the above-referenced article of L.F.Cordes and M. Garfinkel.

It can be appreciated from comparing reverse characteristics 50 and 52 with each other that the gallium arsenide diode can block current up to nearly its ideal reverse breakdown voltage of 200 volts, whereas the prior art silicon diode can only block current up to a reverse voltage of 125 volts. This is the case although the silicon diode utilizes a particular form of edge termination structure, whereas the gallium arsenide diode does not.

It can also be appreciated from comparing reverse characteristics 50 and 52 with each other that the gallium arsenide diode has a desirably low value of reverse leakage current up to nearly its breakdown voltage of approximately 200 volts. On the other hand, the prior art diode suffers from a considerable level of reverse leakage current at all values of reverse voltage. For example, its reverse leakage current has a level of about 1.5 milliamps at 100 volts reverse voltage, compared with the reverse leakage current of the gallium arsenide diode, whose level is about 3 orders of magnitude lower than the reverse leakage current of the silicon diode.

Not only does the high voltage, gallium arsenide diode 10 of FIGURE 1 possess the advantages discussed in relation to FIGURE 2, but it also possesses the highly desirable advantage of having low

-8-

resistance, allowing it to carry about 12 times as much current as a silicon diode, or to be made about one-twelfth the size of a silicon diode, for devices with the same reverse breakdown voltages and forward voltage drops.

Further details of construction of high voltage, gallium arsenide diode 10 are contained in the following articles which were written on our behalf to describe aspects of our invention: B.J. Baliga et al, "Breakdown Characteristics of Gallium Arsenide," IEEE Transactions, Electron Device Letters, Vol. EDL-2, No.11 (November 1981) pages 302-304; B.J. Baliga et al., "Breakdown Stability of Gold Aluminum, and Tungsten Schottky Barriers on Gallium Arsenide," IEEE Electron Device Letters, Vol. EDL-3, No. 7, (July 1982), pages 177-179. The disclosures of the foregoing articles are incorporated herein in their entireties by reference.

While our invention has been described with respect to specific embodiments, many modifications and substitutions will be apparent to those skilled in the art. For example, a complementary Schottky barrier diode could be made, in which P-type material is used rather than N-type material. It is, therefore, to be understood that the appended claims are intended to cover all such modifications and substitutions as fall within the true spirit and scope of the invention.

10216- RD-13,251

HIGH VOLTAGE SCHOTTKY BARRIER DIODE

CLAIMS:

1.    A high voltage Schottky barrier diode comprising:

(a) a body of semiconductor material having a substrate layer and a voltage-supporting layer of gallium arsenide atop the substrate layer, both said layers being doped to one conductivity type;

(b) a first electrode adjoining the voltage-supporting layer and forming a Schottky barrier rectifying contact therewith; and

(c) a second electrode adjoining the substrate layer and forming a non-rectifying contact therewith;

(d) the voltage-supporting layer having a dopant concentration below about $10^{16}$ impurity atoms per cubic centimeter, whereby the diode blocks current at high reverse voltage.

2.    The diode of claim 1 wherein the substrate layer comprises gallium arsenide.

3.    The diode of claim 2 wherein the voltage-supporting layer comprises an epitaxial layer.

4.    The diode of claim 3 wherein the one conductivity type comprises N-type.

5.    The diode of claim 1 wherein the first electrode comprises tungsten.

6.    The diode of claim 5 wherein the tungsten first electrode comprises annealed tungsten.

7. The diode of claim 6 wherein the annealed tungsten first electrode annealing the first electrode at a temperature of about 450°C for a predetermined period of time.

8. The diode of claim 7 wherein the predetermined time is about 60 minutes.

9. The diode of claim 1 wherein the first electrode comprises gold.

*FIG. 1*

SCHOTTKY BARRIER
RECTIFYING CONTACT

10

18

22

GALLIUM
ARSENIDE

12

16 N⁻ ($<10^{16}$ PER CM³)

14 N⁺

20

NON-RECTIFYING
CONTACT

*FIG. 2*

VOLTAGE (VOLTS)

-200   (-125)  -100   0

50

52

SILICON

GALLIUM ARSENIDE

CURRENT (MILLIAMPS)

0

-4

TEMP = 100°C